# EUROPÄISCHE PATENTSCHRIFT

(11) **EP 2 177 568 B1**
(45) Veröffentlichungstag und Bekanntmachung des Hinweises auf die Patenterteilung: **05.11.2014**
(21) Anmeldenummer: 09173176.0
(22) Anmeldetag: 15.10.2009
(51) Int. Cl.: C08G 65/326, C08G 65/331, C08G 65/332, C08L 67/06, C08L 71/02, H05K 3/28

(54) **Imprägnierharz**
Impregnating resin
Résine d'imprégnation

(30) Priorität: 17.10.2008 DE 102008037468
(43) Veröffentlichungstag der Anmeldung: 21.04.2010
(73) Patentinhaber: Elantas GMBH, 46483 Wesel (DE)
(72) Erfinder: Lienert, Klaus-W., 22763, Hamburg (DE); Eberhardt, Marc, 46485, Wesel (DE); Dams, Christian, 46509, Xanten (DE); Hinnerwisch, Jörg, 46483, Wesel (DE); Al-Masri, Majdi, 21244, Buchholz (DE)
(74) Vertreter: Fitzner, Uwe

(56) Entgegenhaltungen:
- EP-A1- 0 017 798
- EP-A2- 0 549 923
- EP-B1- 0 968 501
- WO-A1-2005/121246
- DE-A1- 2 706 575
- US-A- 3 283 032
- DATABASE WPI Week 200618 Thomson Scientific, London, GB; AN 2006-168821 XP002682480, & JP 2006 049071 A (TOSHIBA CHEM CORP) 16. Februar 2006 (2006-02-16)

## Beschreibung

Alle in der vorliegenden Anmeldung zitierten Dokumente sind durch Verweis vollumfänglich in die vorliegende Offenbarung einbezogen (= incorporated by reference in their entirety).

Die vorliegende Erfindung betrifft ein Imprägnierharz für Elektromaschinen das bei Raumtemperatur flüssig und VOC-frei ist und sich auf den üblichen Verarbeitungsanlagen verarbeiten läßt.

### Stand der Technik:

Die Tränkung von elektrischen Wicklungen ist ein Standardvorgang bei der Herstellung von Elektromaschinen. Das ausgehärtete Tränkharz hat die Aufgabe, die Wicklung mechanisch zu fixieren, vor aggressiven Chemikalien und Umwelteinflüssen zu schützen, die gebildete Wärme abzuleiten und elektrisch zu isolieren.

Stand der Technik ist die Verwendung von styrolhaltigen ungesättigten Polyestern. Diese sind allgemein bekannt, und deren Herstellung und Verwendung ist dem Fachmann geläufig. Literatur ist in den üblichen Werken zur Polymerchemie und den Broschüren der Lieferanten zu finden. Außerdem gibt es Tagungsberichte zu konventionell verarbeitbaren (z.B. Varnish and resin usage with various motor construction, M. Winkeler, IEEE Proceedings, 1999, S. 143; Evaluation of electrical insulating resins for inverter duty application, M. Winkeler, IEEE Proceedings 1997, S 145), sowie zu z.B. kalthärtenden Systemen (Heatless cure coating of electrical windings, Th. J. Weiss, IEEE Proceedings, 1993, S. 443).

Da styrolhaltige Harze bei der Härtung Styrol emittieren, muß die Abluft aus den Verarbeitungsanlagen behandelt werden. Werden statt Styrol andere Comonomere, z.B. Vinyltoluol oder verschiedene Acrylate verwendet, ändert sich an den Emissionen prinzipiell nichts.

In der EP 0 968 501 werden flüssige comonomerenfrei härtbare ungesättigte Polyester enthaltende Formulierungen beschrieben, die auch UV-härtbar sind. Der ungesättigte Polyester enthält Dicyclopentadien- und Maleinsäurestrukturen. Allerdings haben diese Formulierungen eine relativ hohe Viskosität. Diese ist für die Verarbeitung auf gängigen Anlagen ein Hindernis. In der EP 1 122 282 werden ebenfalls comonomerenfrei härtbare ungesättigte Polyesterharze enthaltende Formulierungen beschrieben. Sie bestehen aus ungesättigten Polyestern auf Basis von Maleinsäure und Dicyclopentadien und polymeren Vernetzern, in denen z.B. Isoprenol (3-Methyl-3-buten-1-ol) als Baustein eingesetzt wird. Die Viskositäten der Harzmischungen sind teilweise sehr hoch. Außerdem haben die Formulierungen den Nachteil, daß Harze und polymere Vernetzer nicht beliebig gemischt werden können, da der polymere Vernetzer allein nicht härtbar ist.

Es ist bekannt, dass ungesättigte Polyesterharze mit imidhaltigen Strukturen modifiziert werden können und dass diese Produkte thermisch höherwertig sind. In der DE 1 720 323 werden diese kettenständigen Strukturen beschrieben. Ungesättigte Polyesterharze dieses Typs sind mit einem hohen Imidgehalt nicht mehr in Styrol löslich.

Endkettenständige imidmodifizierte ungesättigte Polyesterharze werden in der DE 15 70 273 beschrieben. Da die Anzahl der Kettenenden begrenzt ist, ist der Imidgehalt nicht unbegrenzt zu erhöhen.

Es ist von polyester- und polyesterimidhaltigen Drahtlackharzen bekannt, dass sie sich außer in Kresol auch in Glykolethern des Mono-, Di- und Triethylenglykols lösen. Die US 4,267,231, die US 4,480,007 sowie die J5 7098-573 beschreiben diese.

Aus EP 0 017 798 A1, JP 2006-049071 B und WO 2005/121246 A1 sind Tränkharzzusammensetzungen bekannt, die ungesättigte Polyester bzw. Polyesterimide und verschiedene andere Komponenten enthalten, jedoch keine Sorbate.

Aus DE 27 06 575 A1 und US 3,283,032 sind Zusammensetzungen bekannt, die Polyethersorbate enthalten, jedoch keine Polyesterimide.

### Aufgabe:

Die vorliegende Erfindung hat sich zur Aufgabe gestellt, eine VOC freie Formulierung zu entwickeln, die frei von Monomeren ist, ein ungesättigtes Polyesterharz bzw. ungesättigtes Polyesterimidharz enthält und die zur Imprägnierung von elektrischen Wicklungen geeignet ist.

### Lösung:

Diese Aufgabe wird gelöst durch eineTränkharzformulierung enthaltend Komponente (A), bestehend aus mindestens einem ungesättigten Polyesterharz, das mit ketten- oder endständigen Imidstrukturen modifiziert ist, Komponente (B) bestehend aus einem oder mehreren, bevorzugt einem, Polyether, enthaltend lineare oder verzweigte Polyethylenglykol-, Polypropylengylkol- und/oder Polyethylenglykolpolyproylenglykolstrukturen deren terminale OH-Gruppen alle oder teilweise mit Sorbinsäure verestert sind, gegebenenfalls Komponente (C) bestehend aus einem weiteren von (A) und (B) verschiedenen ungesättigten Polymer oder einem Epoxid/Härter-System, gegebenenfalls Härter, Beschleuniger, Stabilisatoren, Additive und Rheologieadditive, wobei die Komponente (A) von Komponente (B) verschieden ist.

### Begriffsdefinitionen:

Im Rahmen der vorliegenden Erfindung sind alle Mengenangaben, sofern nicht anders angegeben, als Gewichtsangaben zu verstehen.

Sofern nichts anderes angegeben wird, werden die angeführten Reaktionen bzw. Verfahrensschritte bei Normaldruck (Atmosphärendruck) durchgeführt.

Im Rahmen der vorliegenden Erfindung werden unter dem Begriff "Photoinitiator", soweit nicht anders angegeben, sowohl Photosensibilisatoren als auch Photoinitiatoren im engeren Sinne verstanden.

Der Ausdruck (Meth)acryl soll im Rahmen der vorliegenden Erfindung sowohl Methacryl als auch Acryl bzw. Mischungen beider umfassen.

Reaktivverdünner oder reaktive Lösemittel im Rahmen der vorliegenden Erfindung sind entsprechend DIN 55945 Lösemittel, die während der Filmbildung durch chemische Reaktion Bestandteil der Beschichtung werden, vgl. hierzu auch Römpp Lexikon Lacke und Druckfarben, Georg Thieme Verlag, Stuttgart, New York, 1998, "Reaktivverdünner".

### Detaillierte Beschreibung:

Die vorliegende Erfindung betrifft
eine Tränkharzformulierung enthaltend
Komponente (A), bestehend aus mindestens einem ungesättigten Polyesterharz, das mit ketten- oder endständigen Imidstrukturen modifiziert ist, Komponente (B) bestehend aus einem oder mehreren, bevorzugt einem, Polyether, enthaltend lineare oder verzweigte Polyethylenglykol-, Polypropylengylkol- und/oder Polyethylenglykolpolyproylenglykolstrukturen deren terminale OH-Gruppen alle oder teilweise mit Sorbinsäure verestert sind, gegebenenfalls Komponente (C) bestehend aus einem weiteren von (A) und (B) verschiedenen ungesättigten Polymer oder einem Epoxid/Härter-System, gegebenenfalls Härter, Beschleuniger, Stabilisatoren, Additive und Rheologieadditive,
wobei die Komponente (A) von Komponente (B) verschieden ist.

Die Komponente (A) besteht aus einem oder mehreren, bevorzugt einem ungesättigten Polyesterharz, aufgebaut aus Glykolen, Maleinsäure, sowie anderen aus der ungesättigten Polyesterharzchemie bekannten Komponenten. Die so aufgebauten Polyesterharze sind erfindungsgemäß modifiziert mit ketten- oder endständigen Imidstrukturen,und gegebenenfalls zusätzlich mit Dicyclopentadienstrukturen, mit Isocyanaten und/oder Melaminharzen.

Die Komponente (B) besteht aus einem oder mehreren, bevorzugt einem, Polyether, enthaltend lineare oder verzweigte Polyethylenglykol-, Polypropylengylkol- und/oder Polyethylenglykolpolyproylenglykolstrukturen deren terminale OH-Gruppen alle oder teilweise mit Sorbinsäure verestert sind. Die Komponente (C) besteht in einer Variante aus einem oder mehreren, bevorzugt einem, ungesättigten Polymeren, hergestellt durch die Funktionalisierung bestehender Polymere mit Doppelbindungen enthaltenden Molekülen, wie zum Beispiel das Reaktionsprodukt aus einem carbonsäureterminierten Polyacrylat mit Glycidylmethacrylat, oder das Reaktionsprodukt eines Polyetherpolyols mit einem ungesättigten Isocyanat, oder polymere Vinylether, wie zum Beispiel Polyethylenglykoldivinylether unterschiedlichen Molekulargewichts.

In einer zweiten Variante kann die Komponente (C) ein im System (d.h. den restlichen Komponenten) lösliches Epoxidharz mit dem dazugehörigen Härter sein.

In einer weiteren Variante enthält die Komponente (C) ein oder mehrere, bevorzugt ein, ungesättigtes Polymer, hergestellt durch die Funktionalisierung bestehender Polymere mit Doppelbindungen enthaltenden Molekülen und ein im System lösliches Epoxidharz mit dem dazugehörigen Härter, oder die Komponente (C) enthält ein oder mehrere, bevorzugt ein, ungesättigtes Polymer, hergestellt durch die Funktionalisierung bestehender Polymere mit Doppelbindungen enthaltenden Molekülen und ein im System lösliches Epoxidharz mit dem dazugehörigen Härter.

Erfindungsgemäß werden die drei Komponenten gemischt und mit den üblichen Härtern, Beschleunigern, Stabilisatoren und Additiven formuliert. Dadurch erhält man Formulierungen, die abhängig von der Zusammensetzung, ein gutes Härtungsverhalten und gehärtet homogene Formstoffe mit hervorragenden mechanischen, elektrischen und thermischen Eigenschaften.

In einer Variante kann zusätzlich noch Füllstoff zugegeben werden.

Erfindungsgemäß besteht die Komponente (A) aus mindestens einem, bevorzugt genau einem, Bindemittel, das ein ungesättigtes, imdihaltiges Polyesterharz ist. Diese Harze sind bekannt und werden durch die Reaktion von Polyolen, Carbonsäuren und auch monofunktionellen Molekülen als Kettenabbrecher hergestellt. Die Herstellung dieser Harze ist allgemein bekannt. Dabei werden die Komponenten mit oder ohne Veresterungskatalysator üblicherweise auf Temperaturen zwischen 160 und 200°C erhitzt. Die Reaktion wird üblicherweise unter Schutzgas durchgeführt. Um die Austragung des gebildeten Wassers zu erleichtern kann ein Azeotrop und/oder Vakuum verwendet werden. Die Kontrolle des Kondensationverlaufs wird üblicherweise durch die Bestimmung der Säurezahl und/oder der Kondensationsviskosität durchgeführt.

Als Polyole werden Ethylenglykol, Di- und Triethylenglykol, Neopentylglykol, 1,3- und 1,6-Hexandiol, Perhydrobisphenol-A, Glycerin, Trimethylolpropan, Tris-(2-Hydroxyethyl)-Isocyanurat, Pentaerythrit, Dipentaerythrit bevorzugt. Besonders bevorzugt werden Di- und Triethylenglykol, Neopentylglykol und Trimethylolpropan.

Als Carbonsäuren werden bevorzugt verwendet alpha,beta-ungesättigte Dicarbonsäuren oder deren Derivate wie Maleinsäureanhydrid und Fumarsäure und ihre Abmischungen mit modifizierenden Dicarbonsäuren wie Adipinsäure, Bernsteinsäure, Phthalsäureanhydrid, Isophthalsäure, Terephthalsäure, 2,6-Naphthalindicarbonsäure. Besonders bevorzugt werden Maleinsäureanhydrid und Adipinsäure.

Als Kettenabbrecher werden monofunktionelle Carbonsäuren und/oder monofunktionelle Alkohole bevorzugt, z.B. Tallölfettsäure, Benzoesäure, 2-Ethylhexansäure, Hexanol, 2-Ethylhexanol, Benzylalkohol, tert-Butanol, Isoprenol (3-Methyl-3-buten-1-ol). Besonders bevorzugt werden Hexanol, Isoprenol sowie das Reaktionsprodukt von Tetrahydrophthalsäureanhydrid mit Ethanolamin.

Die Imidmodifizierung wird endständig durchgeführt mit dem Reaktionsprodukt von Tetrahydrophthalsäureanhydrid mit Ethanolamin. Die kettenständige Modifizierung wird durchgeführt mit imidgruppenhaltigen Ausgangsstoffen die beispielsweise durch Reaktion zwischen Verbindungen erhalten werden, von denen die eine fünfgliedrige, cyclische Carbonsäureanhydridgruppierung sowie mindestens eine weitere funktionelle Gruppe besitzt, während die andere außer einer primären Aminogruppe noch mindestens eine weitere funktionelle Gruppe enthält. Diese weiteren funktionellen Gruppen sind vor allem Carboxylgruppen oder Hydroxylgruppen. Es können aber auch weitere primäre Aminogruppen oder Carbonsäureanhydridgruppen zum Einsatz kommen.

Beispiele für Verbindungen mit einer cyclischen Carbonsäureanhydridgruppierung und weiteren funktionellen Gruppen sind vor allem Pyromellithsäuredianhydrid und Trimellithsäureanhydrid. Es kommen jedoch auch andere aromatische Carbonsäureanhydride in Frage, beispielsweise die Naphthalintetracarbonsäuredianhydride oder Dianhydride von Tetracarbonsäuren mit zwei Benzolkernen im Molekül, bei denen die Carboxylgruppen in 3,3',4 und 4'-Stellung stehen.

Beispiele für Verbindungen mit einer primären Aminogruppe sind insbesondere diprimäre Diamine, z.B. Ethylendiamin, Tetramethylendiamin, Hexamethylendiamin, Nonamethylendiamin und andere aliphatische diprimäre Diamine.

Ferner kommen in Betracht aromatische diprimäre Diamine, wie Benzidin, Diaminodiphenylmethan, Diaminodiphenylsulfon, -sulfoxid, -ether, -tioether, Phenylendiamine, Toluylendiamine sowie Diamine mit drei Benzolkernen im Molekül, z.B. Bis(4-amino-phenoxy)-1,4-benzol. In Frage kommen schließlich cycloaliphatische Diamine, wie das 4,4'-Dicyclohexylmethandiamin.

Als aminogruppenhaltige Verbindungen mit einer weiteren funktionellen Gruppe sind ferner auch Aminoalkohole verwendbar, z.B. Monoethanolamin und Monopropanolamine, weiterhin Aminocarbonsäuren wie Glycin, Aminopropansäure, Aminocapronsäuren oder Aminobenzoesäuren.

Erfindungsgemäß besteht die Komponente (B) aus mindestens einem, bevorzugt einem, Bindemittel, hergestellt durch die Reaktion eines Polyethers, enthaltend lineare oder verzweigte Polyethylenglykol-, Polypropylengylkol- und/oder Polyethylenglykolpolypropylengylkolstrukturen deren terminale OH-Gruppen alle oder teilweise mit Sorbinsäure verestert sind.

Polyether sind bekannt und werden z.B. als Polyethylenglykol 200, Polyethylenglykol 400, Polyethylenglykol 600 u.s.w. angeboten. Erfindungsgemäß wird so ein kommerziell erhältlicher Polyether mit ungesättigten Carbonsäuren umgesetzt.

Die Veresterung der Sorbinsäure ist beschrieben und kann vom Fachmann nachgelesen werden z.B. in "Use of ion-exchange resins as catalysts in organic synthesis", Polyanskii et al. in Zhurnal Prikladnoi Khimi (1966), 39 (5) 1211-13; "Nonacidic catalytic synthesis of ethyl sorbat", Deng et al. in Guangxi Huagong (2000), 29 (3), 7-8, 10. Die Herstellung der Ester von Polyethern erfolgt analog, vgl. z.B. Dissertation von Johann Schellenberg, "Synthese monomerfreier ungesättigter Polyesterharze mit verbesserten thermischen, elektrischen und rheologischen Eigenschaften", Hamburg 2008. Als Komponente (B) werden erfindungsgemäß demgemäß lineare oder verzweigte Polyethylenglykol-, Polypropylenglykol- und/oder Polyethylenglykolpolypropylenglykolstrukturen deren terminale OH-Gruppen alle oder teilweise mit Sorbinsäure verestert sind, eingesetzt, die besonders bevorzugt ein Polyethylenglykoldisorbat, Polypropylenglykoldisorbat und/oder Polyethylen- Polypropylenglykoldisorbat, insbesondere bevorzugt ein Polyethylenglykoldisorbat, sind. Sehr gute Ergebnisse werden mit Polyethylenglykol-400-disorbat und Polyethylenglykol-600-disorbat erreicht; demgemäß enthält die Komponente (B) in einer bevorzugten Ausführungsform der vorliegenden Erfindung eine oder beide dieser diese beiden Verbindungen oder besteht hieraus. Erfindungsgemäß besonders bevorzugt ist es, wenn die Komponente (B) bei Raumtemperatur (23°C) flüssig ist und als Lösungsmittel für die Komponente (A) und gegebenenfalls (C), sowie die gegebenenfalls vorhandenen üblichen Härter, Beschleuniger, Stabilisatoren und Additive, Rheologieadditive wirkt.

Erfindungsgemäß besteht die Komponente (C) in einer ersten Variante aus mindestens einem, bevorzugt einem, ungesättigten ungesättigten Polymeren, hergestellt durch die Funktionalisierung bestehender Polymere mit Doppelbindungen enthaltenden Molekülen.

Beispiele hierfür sind das Reaktionsprodukt aus einem carbonsäureterminierten Polyacrylat mit Glycidylmethacrylat, das Reaktionsprodukt eines Polyetherpolyols mit einem ungesättigten Isocyanat, polymere Vinylether, wie zum Beispiel Polyethylenglykoldivinylether unterschiedlichen Molekulargewichts.

Beispiele für besonders bevorzugt einsetzbare Polymere (C) sind alkoxylierte Trimethylolpropantriacrylate, wie sie z.B. unter dem Handelsnamen Laromer^{(R)} PO 33F erhältlich sind, oder Polyethylenglycoldivinylether.

Außerdem können in einer anderen Variante als Komponente (C) Epoxidharze, z.B. des Typs Bisphenol-A und Bisphenol-F im Gemisch mit den entsprechenden Mengen anhydridischem Härter, z.B. Methylhexahydrophthalsäureanhydrid oder Dodecylbernsteinsäureanhydrid eingesetzt werden.

Die Varianten der Komponente (C) sind miteinander kombinierbar. Beispielsweise kann die Komponente (C) auch aus alkoxyliertem Trimethylolpropantriacrylat und zusätzlich einem Epoxidharz mit entsprechendem anhydridischem Härter bestehen.

Die erfindungsgemäße Formulierung besteht bevorzugt aus
a) 20 - 80 Gew.-%, bevorzugt 25 - 70 Gew.-%, besonders bevorzugt 30 - 60 Gew.-% Komponente (A),
b) 20 - 80 Gew.-%, bevorzugt 30 - 70 Gew.-%, besonders bevorzugt 35 - 65 Gew.-% Komponente (B),
c) 0 - 40 Gew.-%, bevorzugt 5 - 35 Gew.-%, besonders bevorzugt 10 - 30 Gew.-% Komponente (C),
d) 0,1 - 5 Gew.-%, bevorzugt 0,5 - 4 Gew.-%, besonders bevorzugt 1 - 3 Gew.-% Härtern, Beschleunigern, Stabilisatoren, Additiven, Rheologieadditiven,
wobei sich die prozentualen Angaben auf 100% addieren und auf die gesamte erfindungsgemäße Formulierung beziehen.

In einer Variante besteht die erfindungsgemäße Formulierung bevorzugt aus
I) 20 - 70 Gew.-%, bevorzugt 30 - 60 Gew.-%, besonders bevorzugt 40 - 50 Gew.-% a) + b) + c) + d) und
II) 30 - 80 Gew.-%, bevorzugt 40 - 70 Gew.-%, besonders bevorzugt 50 - 60 Gew.-% Füllstoffen,
wobei sich die prozentualen Angaben von I) und II) auf 100% addieren und auf den Gesamtfeststoff der erfindungsgemäßen Formulierung beziehen und wobei sich die prozentualen Angaben für a) + b) + c) + d) auf 100% addieren und auf die Gesamtsumme aus a) + b) + c) + d) bezogen sind.

Die erfindungsgemäße Formulierung wird hergestellt, indem zunächst die Komponenten (A), (B) und (C) abgemischt werden. Die Zusätze an Härtern, Beschleunigern, Stabilisatoren, Additiven, Rheologieadditiven, sowie gegebenenfalls Füller werden am Ende zugegeben.

Als Härter haben sich bewährt Peroxide, wie z.B. Dicumylperoxid und tert.-Butylperbenzoat sowie silylierte Benzpinakole.

Durch die Verwendung von Photoinitiatoren, wie zum Beispiel Phosphinoxiden und Ketalen ist die Formulierung UV-lichthärtend einzustellen.

Beschleuniger sind Metallseifen, wie z.B. Kobalt-, Vanadium und Zirkonoktoate oder Naphthenate.

Als Stabilisatoren werden alkylierte Phenole, Hydrochinone und Benzochinone, wie z.B. 2,4-Ditert.-butylphenol oder Methylhydrochinon verwendet.

Additive sind die dem Fachmann bekannten Verlaufs und Oberflächenadditive. Als rheologische Zusätze haben sich pyrogene Kieselsäuren, Bentone und polymere Harnstoffe bewährt.

Als Füllstoffe haben sich Stoffe ausgewählt aus der Gruppe bestehend aus Quarzmehl, Quarzgut, Kreide, Dolomit, Aluminiumhydroxid, Magnesiumhydroxid, Basalt, roter Phosphor, Ammoniumpolyphosphat, Melaminverbindungen und Kombinationen davon bewährt und werden demgemäß erfindungsgemäß bevorzugt eingesetzt.

Es sei im Hinblick auf die Härter, Beschleuniger, Stabilisatoren, Additive, Rheologieadditive, sowie Füller auf die Lackhandbücher verwiesen, z.B. Römpp Lexikon Lacke und Druckfarben, Georg Thieme Verlag, Stuttgart, New York, 1998; Lehrbuch "Lackadditive" von Johan Bieleman, Wiley-VCH, Weinheim, New York, 1998; "Paints, Coatings and Solvents", second completely revised edition, Edit. D. Stoye und W. Freitag, Wiley-VCH, Weinheim, New York, 1998.

Die erfindungsgemäße Tränkharzformulierung ist bei Raumtemperatur flüssig, und comonomerenfrei. Sie lässt sich auf den üblichen Verarbeitungsanlagen verarbeiten, z.B. durch Tauchen, Träufeln, Tauchrollieren, Gießen und durch Vakuum- und Vakuum-Druckimprägnierung von elektrischen Wicklungen. Besonderer Vorteil der vorliegenden Erfindung ist, daß die Formulierung kein Styrol als Lösungsmittel enthält.

Im Anschluss an die beschriebene Verarbeitung der Tränkharzformulierung wird gehärtet. Hierbei kann es sich um eine thermische Härtung handeln. Diese kann entweder in einem Ofen oder durch die Stromwärme der Wicklung oder durch die Kombination dieser Möglichkeiten erreicht werden.

Die Härtung kann auch mittels Strahlung, vorzugsweise mittels UV-Strahlung, erreicht werden. Insbesondere, wenn die Tränkharzformulierung mit einem Photoinitiator versehen ist, kann sie auf dem Blechpaket mit Hilfe von UV-Licht gehärtet werden.

Möglich ist erfindungsgemäß auch die Kombination von thermischer Härtung und UV-Licht-Härtung, insbesondere, wenn eine Härtung direkt auf dem Blechpaket vorgesehen ist.

Dabei wird die gleichzeitige Nutzung von Ofenwärme und/oder Stromwärme (Wicklungswärme) und UV-Licht für die Härtung ermöglicht.

Neben der Imprägnierung von elektrischen Wicklungen kann die erfindungsgemäße Tränkharzformulierung auch zum Überzug von Flachbaugruppen in der Elektronik, Hybriden, SMD-Baugruppen, und bestückten Leiterplatten eingesetzt werden, oder als Basismaterial für flächige Isolierstoffe verwendet werden.

Ebenso ist es, versetzt mit Füllstoffen, als Gießharz für Spulen und Transformatoren geeignet.

Ferner wurde im Rahmen der vorliegenden Erfindung die Verwendung von Polyethylenglykol-, Polypropylenglykol- und/oder Polyethylenglykolpolypropylenglykolstrukturen deren terminale OH-Gruppen alle oder teilweise mitSorbinsäure verestert sind, insbesondere Polyethylenglykoldisorbat, Polypropylenglykoldisorbat und/oder Polyethylen-Polypropylenglykoldisorbat, als Reaktivverdünner für Tränkharze gefunden.

In einer Variante dieser erfindungsgemäßen Verwendung enthält das Tränkharz ein ungesättigtes Polyesterharz, wobei die Tränkharze imidhaltige Polyesterharze enthalten.

In einer Variante dieser erfindungsgemäßen Verwendung ist es bevorzugt, wenn die Tränkharze neben einem ungesättigten Polyesterharz mindestens
- ein weiteres, von dem ungesättigten Polyesterharz verschiedenes ungesättigtes Polymer enthalten, welches bevorzugt durch die Funktionalisierung bestehender Polymere mit Doppelbindungen enthaltenden Molekülen hergestellt wird, insbesondere alkoxyliertes Trimethylolpropantriacrylat, oder
- ein Gemisch aus Epoxidharz mit dem dazugehörigen Anhydridhärter enthalten.

Es ist im Rahmen dieser erfindungsgemäßen Verwendung auch möglich, diese Varianten zu kombinieren.

Ferner ist es möglich, bei der erfindungsgemäßen Verwendung von Polyethylenglykoldisorbat, Polypropylenglykoldisorbat und/oder Polyethylen-Polypropylenglykoldisorbat als Reaktivverdünner für Tränkharze die Disorbate teilweise (bis zu 70%) durch Monosorbate zu ersetzen.

Die verschiedenen Ausgestaltungen der vorliegenden Erfindung, z.B. diejenigen der verschiedenen abhängigen Ansprüche, können dabei in beliebiger Art und Weise miteinander kombiniert werden.

Im folgenden wird die Erfindung unter Bezugnahme auf Beispiele näher beschrieben. Die Ausprüfung erfolgt nach DIN und IEC-Normen. Sofern bei den Viskositätsmessungen kein Lösungsmittel angegeben ist, erfolgte die Messung mit der Substanz an sich.

### Beispiels:

### Beispiel 1 Herstellung Polyethylenglykol-400-disorbat 1

In einer Standard-Dreihalskolbenapparatur wurden unter Schutzgas 213g Sorbinsäure und 1,0g lonol CP (2,6-Di-tert.-butylkresol) vorgelegt. Es wurde auf 100°C erwärmt und 380g PEG 400 zugegeben. Anschließend wurden 1,9g Schwefelsäure zugegeben. Die Veresterung erfolgte zwischen 120° und 145°C. Nach Beendigung der Reaktion wurde die Schwefelsäure mit Natronlauge neutralisiert. Das Natriumsulfat wurde abgetrennt und das Lösemittel abdestilliert. Man erhielt eine viskose Flüssigkeit (500 mPas, 23°C) die 2,7% PEG 400 und 18% Monoester enthält.

### Beispiel 2 Herstellung Polyethylenglykol-600-disorbat 2

In einer Standard-Dreihalskolbenapparatur wurden unter Schutzgas 213g Sorbinsäure und 1,0g lonol CP vorgelegt. Es wurde auf 100°C erwärmt und 570g PEG 600 zugegeben. Anschließend wurden 1,9g Schwefelsäure zugegeben. Die Veresterung erfolgte zwischen 120° und 145°C. Nach Beendigung der Reaktion wurde die Schwefelsäure mit Natronlauge neutralisiert. Das Natriumsulfat wurde abgetrennt und das Lösemittel abdestilliert. Man erhielt eine viskose Flüssigkeit (1500 mPas, 23°C) die 1,6% PEG 600 und 16% Monoester enthält.

### Beispiel 3 Herstellung eines imidhaltigen ungesättigten Polyesterharzes 1

In einer Standard-Dreihalskolbenapparatur wurden unter Stickstoff 611g Neopentylglykol, 544g Maleinsäureanhydrid, 192g Trimellithsäureanhydrid und 620g des Reaktionsproduktes aus Tetrahydrophthalsäureanhydrid mit Ethanolamin bei 180°C in Gegenwart von 0,1g Dibutylzinnoxid und 0,1g Hydrochinon umgesetzt. Die Reste von Kondensationswasser wurden im Wasserstrahlvakuum abdestilliert. Bei einer Säurezahl von 20 mg KOH/g wurde die Reaktion abgebrochen und das Harz abgekühlt und gemahlen.

### Beispiel 4 Herstellung eines imdihaltigen ungesättigten Polyesterharzes 2

In einer Standard-Dreihalskolbenapparatur wurden unter Stickstoff 148g 4,4'-Dicyclohexylmethandiamin und 269g Trimellithsäureanhydrid bei 200°C umgesetzt bis die Wasserabspaltung beendet war. Danach wurden in den Kolben 276g Neopentylglykol, 312g Maleinsäureanhydrid, 134g Trimellithsäureanhydrid und 434g des Reaktionsproduktes aus Tetrahydrophthalsäureanhydrid mit Ethanolamin und 0,1g Dibutylzinnoxid und 0,1g Hydrochinon zugegeben. Bei 180°C erfolgte die Polykondensationsreaktion. Die Reste von Wasser wurden im Wasserstrahlvakuum abdestilliert. Bei einer Säurezahl von 20 mg KOH/g wurde die Reaktion abgebrochen und das Harz abgekühlt und gemahlen.

### Beispiel 5 Lösungsversuch in Styrol

50g des imidhaltigen ungesättigten Polyesterharzes 1 wurden mit 50g Styrol gemischt. Der Ansatz wurde vorsichtig auf 120°C erwärmt. Beim Abkühlen wurde eine trübe Lösung erhalten. Die Verwendung zur Imprägnierung einer Wicklung war mit dem Material nicht möglich.

### Beispiel 6 Lösungsversuch in Styrol

50g des imidhaltigen ungesättigten Polyesterharzes 2 wurden mit 50g Styrol gemischt. Der Ansatz wurde vorsichtig auf 120°C erwärmt. Beim Abkühlen wurde eine trübe Lösung erhalten. Die Verwendung zur Imprägnierung einer Wicklung war mit dem Material nicht möglich.

### Beispiel 7 Herstellung einer Imprägnierharzformulierung mit dem imidhaltigen ungesättigten Polyesterharz 1

1000g Polyesterharz 1 und 800g Polyethylenglykol-600-disorbat 2, 1g Kobaltoctoat, 1g Di-tert. Butylphenol, 20g tert. Butylperbenzoat wurden intensiv gemischt. Die Formulierung hatte eine Viskosität von 1800 mPa*s und eine Gelzeit von 18 Minuten bei 120°C. Mit der Formulierung wurden Drillstäbe nach IEC 61033 (Methode A) getränkt und nach der Härtung (1 Stunde bei 160°C) wurde die Verbackungsfestigkeit bestimmt. Sie betrug bei 155°C 70N. Außerdem wurde mit der Formulierung ein Stator, Größe 90, getaucht und 1 Stunde bei 150°C gehärtet. Der Stator wurde danach zersägt und Harzaufnahme und Tränkqualität optisch begutachtet. Der Stator war einwandfrei imprägniert und die Wicklung satt mit Harz gesättigt.

### Beispiel 8 Herstellung einer Imprägnierharzformulierung mit dem imidhaltigen ungesättigten Polyesterharz 2

1000g Polyesterharz 2 und 1200g Polyethylenglykol-400-disorbat 1, 1g Kobaltoctoat, 1g Di-tert. Butylphenol, 25g tert. Butylperbenzoat wurden intensiv gemischt. Die Formulierung hatte eine Viskosität von 800 mPa*s und eine Gelzeit von 13 Minuten bei 120°C. Mit der Formulierung wurden Drillstäbe nach IEC 61033 (Methode A) getränkt und nach der Härtung (1 Stunde bei 160°C) wurde die Verbackungsfestigkeit bestimmt. Sie betrug bei 155°C 85N. Außerdem wurde mit der Formulierung ein Stator, Größe 90, getaucht und 1 Stunde bei 150°C gehärtet. Der Stator wurde danach zersägt und Harzaufnahme und Tränkqualität optisch begutachtet. Der Stator war einwandfrei imprägniert und die Wicklung satt mit Harz gesättigt.

### Beispiel 9 Herstellung einer Imprägnierharzformulierung mit dem imidhaltigen ungesättigten Polyesterharz 2

1000g Polyesterharz 2, 1200g Polyethylenglykol-400-disorbat 1, 700g Laromer^{(R)} PO 33 F, 1,1g Kobaltoctoat, 1,6g Di-tert. Butylphenol, 33g tert. Butylperbenzoat wurden intensiv gemischt. Die Formulierung hatte eine Viskosität von 600 mPa*s und eine Gelzeit von 10 Minuten bei 120°C. Mit der Formulierung wurden Drillstäbe nach IEC 61033 (Methode A) getränkt und nach der Härtung (1 Stunde bei 160°C) wurde die Verbackungsfestigkeit bestimmt. Sie betrug bei 155°C 52N. Außerdem wurde mit der Formulierung ein Stator, Größe 90, getaucht und 1 Stunde bei 150°C gehärtet. Der Stator wurde danach zersägt und Harzaufnahme und Tränkqualität optisch begutachtet. Der Stator war einwandfrei imprägniert und die Wicklung satt mit Harz gesättigt.

### Beispiel 10 Herstellung einer Imprägnierharzformulierung mit dem imidhaltigen ungesättigten Polyesterharz 2

1000g Polyesterharz 2, 1200g Polyethylenglykol-400-disorbat 1, 188g eines handelsüblichen, flüssigen Bisphenol-A Diglycidethers, 84g Methylhexahydrophthalsäureanhydrid, 1,1g Kobaltoctoat, 1g Di-tert. Butylphenol, 28g tert. Butylperbenzoat wurden intensiv gemischt. Die Formulierung hatte eine Viskosität von 1700 mPa*s und eine Gelzeit von 20 Minuten bei 120°C. Mit der Formulierung wurden Drillstäbe nach IEC 61033 (Methode A) getränkt und nach der Härtung (1 Stunde bei 160°C) die Verbackungsfestigkeit bestimmt. Sie betrug bei 155°C 90N. Außerdem wurde mit der Formulierung ein Stator, Größe 90, getaucht und 2 Stunden bei 170°C gehärtet. Der Stator wurde danach zersägt und Harzaufnahme und Tränkqualität optisch begutachtet. Der Stator war einwandfrei imprägniert und die Wicklung satt mit Harz gesättigt.

## Patentansprüche

1. Tränkharzformulierung enthaltend
Komponente (A), bestehend aus mindestens einem ungesättigten Polyesterharz, das mit ketten- oder endständigen Imidstrukturen modifiziert ist,
Komponente (B) bestehend aus einem oder mehreren, bevorzugt einem, Polyether, enthaltend lineare oder verzweigte Polyethylenglykol-, Polypropylengylkol- und/oder Polyethylenglykolpolyproylenglykolstrukturen deren terminale OH-Gruppen alle oder teilweise mit Sorbinsäure verestert sind, gegebenenfalls Komponente (C) bestehend aus einem weiteren von (A) und (B) verschiedenen ungesättigten Polymer oder einem Epoxid/Härter-System,
gegebenenfalls Härter, Beschleuniger, Stabilisatoren, Additive und Rheologieadditive,
wobei die Komponente (A) von Komponente (B) verschieden ist.

2. Tränkharzformulierung nach Anspruch 1 bestehend aus
a) 20 - 80 Gew.-%, bevorzugt 25 - 70 Gew.-%, besonders bevorzugt 30 - 60 Gew.-% Komponente (A),
b) 20 - 80 Gew.-%, bevorzugt 30 - 70 Gew.-%, besonders bevorzugt 35 - 65 Gew.-% Komponente (B),
c) 0 - 40 Gew.-%, bevorzugt 5 - 35 Gew.-%, besonders bevorzugt 10 - 30 Gew.-% Komponente (C),
d) 0,1 - 5 Gew.-%, bevorzugt 0,5 - 4 Gew.-%, besonders bevorzugt 1 - 3 Gew.-% Härtern, Beschleunigern, Stabilisatoren, Additiven, Rheologieadditiven,
wobei sich die prozentualen Angaben auf 100% addieren und auf die gesamte Formulierung beziehen.

3. Tränkharzformulierung nach Anspruch 1 bestehend aus
I) 20 - 70 Gew.-%, bevorzugt 30 - 60 Gew.-%, besonders bevorzugt 40 - 50 Gew.%
a) 20 - 80 Gew.-%, bevorzugt 25 - 70 Gew.-%, besonders bevorzugt 30 - 60 Gew.-% Komponente (A),
b) 20 - 80 Gew.-%, bevorzugt 30 - 70 Gew.-%, besonders bevorzugt 35 - 65 Gew.-% Komponente (B),
c) 0 - 40 Gew.-%, bevorzugt 5 - 35 Gew.-%, besonders bevorzugt 10 - 30 Gew.-% Komponente (C),
d) 0,1 - 5 Gew.-%, bevorzugt 0,5 - 4 Gew.-%, besonders bevorzugt 1 - 3 Gew.-% Härtern, Beschleunigern, Stabilisatoren, Additiven, Rheologieadditiven,
wobei sich die prozentualen Angaben für a) + b) + c) + d) auf 100% addieren und auf die Gesamtsumme aus a) + b) + c) + d) bezogen sind, und
II) 30 - 80 Gew.-%, bevorzugt 40 - 70 Gew.-%, besonders bevorzugt 50 - 60 Gew.% Füllstoffen,
wobei sich die prozentualen Angaben von I) und II) auf 100% addieren und auf den Gesamtfeststoff der Formulierung beziehen.

4. Tränkharzformulierung nach einem der vorhergehenden Ansprüche, **dadurch gekennzeichnet, dass** Komponente (B) ein Polyethylenglykoldisorbat, Polypropylenglykoldisorbat und/oder Polyethylen- Polypropylenglykoldisorbat, besonders bevorzugt ein Polyethylenglykoldisorbat, ist.

5. Tränkharzformulierung nach einem der vorhergehenden Ansprüche, **dadurch gekennzeichnet, dass** das ungesättigte Polymer in Komponente (C) durch die Funktionalisierung bestehender Polymere mit Doppelbindungen enthaltenden Molekülen hergestellt wird oder ein Gemisch aus Epoxidharz mit dem dazugehörigen Anhydridhärter darstellt.

6. Tränkharzformulierung nach einem der vorhergehenden Ansprüche, **dadurch gekennzeichnet, dass** die Komponenten (A), (B) und (C) durch den Zusatz von Radikalbildnern zu duroplastischen Formstoffen aushärtbar sind.

7. Verwendung der Tränkharzformulierung nach Anspruch 1 bis 6 zum Imprägnieren von elektrischen Wicklungen.

8. Verwendung nach Anspruch 7 zum Imprägnieren von elektrischen Wicklungen durch Tauchen, Träufeln, Tauchrollieren, Vergießen, Vakuum- und/oder Vakuum-Druckimprägnierung gefolgt von einer thermischen Härtung.

9. Verwendung nach Anspruch 7 zum Imprägnieren von elektrischen Wicklungen durch Tauchen, Träufeln, Tauchrollieren, Vergießen, Vakuum- und/oder Vakuum-Druckimprägnierung gefolgt von einer UV-Härtung in Kombination mit einer thermischen Härtung.

10. Verwendung der Tränkharzformulierung nach Anspruch 1 bis 6 zur Herstellung von Basismaterialien von Flächenisolierstoffen.

11. Verwendung der Tränkharzformulierung nach Anspruch 1 bis 6 zum Überziehen von Flachbaugruppen in der Elektronik, Hybriden, SMD-Baugruppen und bestückten Leiterplatten.

12. Verwendung von Polyethylenglykoldisorbat, Polypropylenglykoldisorbat und/oder Polyethylen-Polypropylenglykoldisorbat als Reaktivverdünner für Tränkharze, **dadurch gekennzeichnet, dass** die Tränkharze imidhaltige Polyesterharze enthalten.

13. Verwendung nach Anspruch 12, **dadurch gekennzeichnet, dass** die Tränkharze neben einem ungesättigten Polyesterharz mindestens
- ein weiteres, von dem ungesättigten Polyesterharz verschiedenes ungesättigtes Polymer enthalten, welches bevorzugt durch die Funktionalisierung bestehender Polymere mit Doppelbindungen enthaltenden Molekülen hergestellt wird, insbesondere alkoxyliertes Trimethylolpropantriacrylat, oder
- ein Gemisch aus Epoxidharz mit dem dazugehörigen
Anhydridhärter
enthalten.

## Claims

1. Impregnating resin formulation comprising component (A), consisting of at least one unsaturated polyester resin modified with internal or terminal imide structures,
component (B), consisting of one or more polyethers, preferably one polyether, comprising linear or branched polyethylene glycol, polypropylene glycol and/or polyethylene glycol polypropylene glycol structures some or all of whose terminal OH groups are esterified with sorbic acid,
optionally component (C), consisting of a further unsaturated polymer, different from (A) and (B), or of an epoxy/hardener system,
optionally curing agents, accelerators, stabilizers, additives and rheological adjuvants,
where component (A) is different from component (B).

2. Impregnating resin formulation according to Claim 1, consisting of
a) 20 - 80 wt%, preferably 25 - 70 wt%, more preferably 30 - 60 wt% of component (A),
b) 20 - 80 wt%, preferably 30 - 70 wt%, more preferably 35 - 65 wt% of component (B),
c) 0 - 40 wt%, preferably 5 - 35 wt%, more preferably 10 - 30 wt% of component (C),
d) 0.1 - 5 wt%, preferably 0.5 - 4 wt%, more preferably 1 - 3 wt% of curing agents, accelerators, stabilizers, additives and rheological adjuvants,
where the percentage figures add up to 100% and are based on the overall formulation.

3. Impregnating resin formulation according to Claim 1, consisting of
I) 20 - 70 wt%, preferably 30 - 60 wt%, more preferably 40 - 50 wt%
a) 20 - 80 wt%, preferably 25 - 70 wt%, more preferably 30 - 60 wt% of component (A),
b) 20 - 80 wt%, preferably 30 - 70 wt%, more preferably 35 - 65 wt% of component (B),
c) 0 - 40 wt%, preferably 5 - 35 wt%, more preferably 10 - 30 wt% of component (C),
d) 0.1 - 5 wt%, preferably 0.5 - 4 wt%, more preferably 1 - 3 wt% of curing agents, accelerators, stabilizers, additives and rheological adjuvants,
where the percentage figures for a) + b) + c) + d) add up to 100% and are based on the overall sum of a) + b) + c) + d, and
II) 30 - 80 wt%, preferably 40 - 70 wt%, more
preferably 50 - 60 wt% of fillers,
where the percentage figures for I) and II) add up to 100% and are based on the overall solids of the formulation.

4. Impregnating resin formulation according to any of the preceding claims, **characterized in that** component (B) is a polyethylene glycol disorbate, polypropylene glycol disorbate and/or polyethylene-polypropylene glycol disorbate, more preferably a polyethylene glycol disorbate.

5. Impregnating resin formulation according to any of the preceding claims, **characterized in that** the unsaturated polymer in component (C) is prepared by the functionalization of existing polymers with molecules containing double bonds, or represents a mixture of epoxy resin with the associated anhydride hardener.

6. Impregnating resin formulation according to any of the preceding claims, **characterized in that** components (A), (B) and (C) are curable by the addition of radical formers to thermoset moulding materials.

7. Use of the impregnating resin formulation according to Claims 1 to 6 for impregnating electrical windings.

8. Use according to Claim 7 for impregnating electrical windings by dipping, trickling, dip-rolling, casting, vacuum impregnation and/or vacuum-pressure impregnation followed by a thermal cure.

9. Use according to Claim 7 for impregnating electrical windings by dipping, trickling, dip-rolling, casting, vacuum impregnation and/or vacuum-pressure impregnation followed by a UV cure in combination with a thermal cure.

10. Use of the impregnating resin formulation according to Claims 1 to 6 for producing base materials of sheet insulating materials.

11. Use of the impregnating resin formulation according to Claims 1 to 6 for coating flat modules in electronics, hybrids, SMD modules and assembled printed circuit boards.

12. Use of polyethylene glycol disorbate, polypropylene glycol disorbate and/or polyethylene-polypropylene glycol disorbate as reactive diluents for impregnating resins, **characterized in that** the impregnating resins comprise imide-containing polyester resins.

13. Use according to Claim 12, **characterized in that** the impregnating resins comprise not only an unsaturated polyester resin but also at least
- one further unsaturated polymer, different from the unsaturated polyester resin, which is prepared preferably by the functionalization of existing polymers with molecules containing double bonds, more particularly alkoxylated trimethylolpropane triacrylate, or
- a mixture of epoxy resin with the associated anhydride hardener.

## Revendications

1. Composition de résine d'imprégnation, contenant un composant (A), constitué d'au moins une résine polyester insaturée, qui est modifiée avec des structures imide sur la chaîne ou en bout de chaîne,
un composant (B) constitué d'un ou de plusieurs polyéthers, de préférence d'un polyéther, contenant des structures polyéthylèneglycol, polypropylèneglycol et/ou polyéthylèneglycolpolypropylèneglycol, linéaires ou ramifiées, dont les groupes OH terminaux sont en partie ou en totalité estérifiés par l'acide sorbique, éventuellement un composant (C) constitué d'un système époxyde/durcisseur ou d'un autre polymère insaturé différent de (A) et (B),
éventuellement de durcisseurs, accélérateurs, stabilisants, additifs et additifs de rhéologie,
le composant (A) étant différent du composant (B).

2. Composition de résine d'imprégnation selon la revendication 1, constituée de
a) 20 - 80 % en poids, de préférence 25 - 70 % en poids, de façon particulièrement préférée 30 - 60 % en poids de composant (A),
b) 20 - 80 % en poids, de préférence 30 - 70 % en poids, de façon particulièrement préférée 35 - 65 % en poids de composant (B),
c) 0 - 40 % en poids, de préférence 5 - 35 % en poids, de façon particulièrement préférée 10 - 30 % en poids de composant (C),
d) 0,1 - 5 % en poids, de préférence 0,5 - 4 % en poids, de façon particulièrement préférée 1 - 3 % en poids de durcisseurs, accélérateurs, stabilisants, additifs et additifs de rhéologie,
la somme des données en pourcentage étant égale à 100 % et se rapportant à la composition totale.

3. Composition de résine d'imprégnation selon la revendication 1, constituée de
I) 20 - 70 % en ponds, de préférence 30 - 60 % en poids, de façon particulièrement préférée 40 - 50 % en ponds de
a) 20 - 80 % en poids, de préférence 25 - 70 % en poids, de façon particulièrement préférée 30 - 60 % en poids de composant (A),
b) 20 - 80 % en poids, de préférence 30 - 70 % en poids, de façon particulièrement préférée 35 - 65 % en poids de composant (B),
c) 0 - 40 % en poids, de préférence 5 - 35 % en poids, de façon particulièrement préférée 10 - 30 % en poids de composant (C),
d) 0,1 - 5 % en poids, de préférence 0,5 - 4 % en poids, de façon particulièrement préférée 1 - 3 % en poids de durcisseurs, accélérateurs, stabilisants, additifs, additifs de rhéologie,
la somme des données en pourcentage de a) + b) + c) + d) étant égale à 100 % et se rapportant à la somme totale de a) + b) + c) + d),
et
II) 30 - 80 % en poids, de préférence 40 - 70 % en poids, de façon particulièrement préférée 50 - 60 % en poids de charges,
la somme des données en pourcentage de I) et II) étant égale à 100 % et se rapportant à la matière solide totale de la composition.

4. Composition de résine d'imprégnation selon l'une quelconque des revendications précédentes, **caractérisée en ce que** le composant (B) est un disorbate de polyéthylèneglycol, disorbate de polypropylèneglycol et/ou disorbate de polyéthylène-polypropylèneglycol, de façon particulièrement préférée un disorbate de polyéthylèneglycol.

5. Composition de résine d'imprégnation selon l'une quelconque des revendications précédentes, **caractérisée en ce que** le polymère insaturé dans le composant (C) est préparé par la fonctionnalisation de polymères existants avec des molécules contenant des doubles liaisons ou représente un mélange de résine époxy avec le durcisseur anhydride correspondant.

6. Composition de résine d'imprégnation selon l'une quelconque des revendications précédentes, **caractérisée en ce que** les composants (A), (B) et (C) sont durcissables par l'addition de générateurs de radicaux à des matières à mouler thermodurcissables.

7. Utilisation de la composition de résine d'imprégnation selon l'une quelconque des revendications 1 à 6, pour l'imprégnation de bobinages électriques.

8. Utilisation selon la revendication 7, pour l'imprégnation de bobinages électriques par trempage, instillation, enduction au rouleau trempé, coulée, imprégnation sous vide et/ou sous vide-pression, suivis d'un durcissement thermique.

9. Utilisation selon la revendication 7, pour l'imprégnation de bobinages électriques par trempage, instillation, enduction au rouleau trempé, coulée, imprégnation sous vide et/ou sous vide-pression, suivis d'un durcissement aux UV en association avec un durcissement thermique.

10. Utilisation de la composition de résine d'imprégnation selon l'une quelconque des revendications 1 à 6, pour la production de matériau de base d'isolants de surface.

11. Utilisation de la composition de résine d'imprégnation selon l'une quelconque des revendications 1 à 6, pour le recouvrement d'ensembles de blocs plats dans l'électronique, d'hybrides, d'ensembles de blocs SMD et de plaques à circuits imprimés pastillées.

12. Utilisation de disorbate de polyéthylèneglycol, disorbate de polypropylèneglycol et/ou disorbate de polyéthylènepolypropylèneglycol en tant que diluant réactif pour résines d'imprégnation, **caractérisée en ce que** les résines d'imprégnation contiennent des résines polyester contenant des imides.

13. Utilisation selon la revendication 12, **caractérisée en ce que** les résines d'imprégnation contiennent, outre une résine polyester insaturée, au moins
- un autre polymère insaturé différent de la résine polyester insaturée, qui est préparé de préférence par la fonctionnalisation de polymères existants avec des molécules contenant des doubles liaisons, en particulier du triacrylate de triméthylol-propane alcoxylé, ou
- un mélange de résine époxy avec le durcisseur anhydride correspondant.
